Europäisches Patentamt

European Patent Office

Office européen des brevets

(11) Publication number: **0 516 170 A2**

# EUROPEAN PATENT APPLICATION

(21) Application number: **92109134.4**

(22) Date of filing: **29.05.92**

(51) Int. Cl.⁵: **H01L 21/58**, H01L 21/60

(30) Priority: **28.05.91 JP 123368/91**

(43) Date of publication of application:
**02.12.92 Bulletin 92/49**

(84) Designated Contracting States:
**DE FR GB**

(71) Applicant: Oki Electric Industry Co., Ltd.
7-12, Toranomon 1-chome Minato-ku
Tokyo(JP)

(72) Inventor: Anasako, Kenichi, c/o Oki Electric
Ind. Co. Ltd.
7-12, Toranomon 1-chome, Minato-ku
Tokyo(JP)
Inventor: Homma, Rokuro
c/o Oki Electric Ind. Co. Ltd 7-12
Toranomon 1-chome, Minato-ku Tokyo(JP)

(74) Representative: Betten & Resch
Reichenbachstrasse 19
W-8000 München 5(DE)

(54) **Semiconductor chip mounted circuit board assembly and method for manufacturing the same.**

(57) A circuit board assembly comprises an electrical insulating circuit board with at least one hollow, a semiconductor IC chip mounted in the hollow wherein the upper surfaces of the circuit board and the semiconductor IC chip has the same surface level, the semiconductor IC chip having bonding pads on the upper surface thereof; a wiring pattern connected to one of the bonding pads of the semiconductor IC chip and extending over the surface of the insulating circuit board; and an insulating material layer filled between the semiconductor IC chip and side walls of the hollow so as to fix securely the semiconductor IC chip.

*Fig. 1*

## Background of the Invention

The present invention relates to a circuit board mounting semiconductor IC chips, and a method for manufacturing the same.

## Description of the Related Arts

Present years, high dense, integrated circuit (IC) mounted circuit boards have been used widely for many electric applications because they can miniaturize electronic systems. Conventional printed circuit boards mount a large number of packaged IC devices on the upper surfaces of them. In order to increase the mounting density more, various IC chip mounting methods have been developed to mount directly semiconductor IC chips on the surface of a printed circuit board.

Typically, there are wire bonding method, tape automated bonding (TAB) method, and flip-chip method. In the wire bonding method, the bonding pads on an IC chips are connected to the wiring pattern on the printed circuit board by using fine Au wires connecting between the bonding pads on the upper surface of the IC chip and the lands of the circuit board. In the TAB method, the bonding pads of an IC chip and the wiring patterns on a tape carrier are electrically connected to each other simultaneously. In the flip-chip method, an IC chip has solder bumps on the bonding pads. The IC chip is electrically connected to the wiring patterns on a printed circuit board by facing the solder bumps to the wiring patterns on the printed circuit board, and by melting the solder bumps.

However, both of the wire bonding method and the TAB method requires wider bonding space on the printed circuit board because of using intermediate wiring between the bonding pads of an IC chip and the wiring pattern on a printed circuit board. Furthermore, the above two bonding methods require special bonding apparatus to perform the intermediate wiring process.

The flip-chip method has disadvantages in that IC chips becomes expense in cost because solder bumps are formed on electrodes thereof, and the connection reliability cannot be confirmed because the connected potion sandwiched between the IC chip and the printed circuit board is invisible.

In order to overcome the above mentioned shortcomings, one of the objects of the present invention is to provide a circuit board assembly having high reliability in connection between a bonding pad of a semiconductor IC chip and a wiring pattern of a circuit board.

Another object of the present invention is to provide a circuit board assembly where the electrical connections for electrodes of an IC chip are formed simultaneously with the formation of wiring patterns on a printed circuit board.

Still another object of the present invention is to provide a circuit board assembly making method which can be performed connecting a semiconductor IC chip and a circuit board without performing wire bonding process.

## Summary of the invention

In order to overcome the above mentioned problems, a circuit board assembly according to the present invention comprises an electrical insulating circuit board with at least one hollow, a semiconductor IC chip mounted in the hollow wherein the upper surfaces of the circuit board and the semiconductor IC chip has the same surface level, the semiconductor IC chip having bonding pads on the upper surface, a wiring pattern connected to one of the bonding pads of the semiconductor IC chip and extending over the surface of the insulating circuit board, and an insulating material layer filled between the semiconductor IC chip and side walls of the hollow so as to fix securely the semiconductor IC chip.

A method of manufacturing a circuit board assembly according to the present invention comprises the steps of preparing an electrical insulating circuit board with at least one hollow and a semiconductor IC chip having bonding pads on the upper surface; coating an adhesive layer in the hollow of the electrical insulating circuit board; mounting the IC chips into the hollow of the electrical insulating circuit board so as to make a flat surface of the IC chips and the electrical insulating circuit board; filling an insulating material between the gap of the semiconductor IC chip and side walls of said hollow so as to fix securely the semiconductor IC chip; forming wiring patterns on the surfaces of the semiconductor IC chips and the electrical insulating circuit board.

## Brief Description of the Drawings

Fig. 1 is a perspective view, having a side cross-sectional view, of a semiconductor IC chip mounted circuit board according to the present invention.

Figs. 2(A) to 2(D) are cross-sectional views used for explaining the method of manufacturing a circuit board, according to the present invention.

Fig. 3 is a perspective view showing a semiconductor IC chip molded into an opening with an open end formed in a circuit board.

## Detailed Description of the Preferred Embodiments

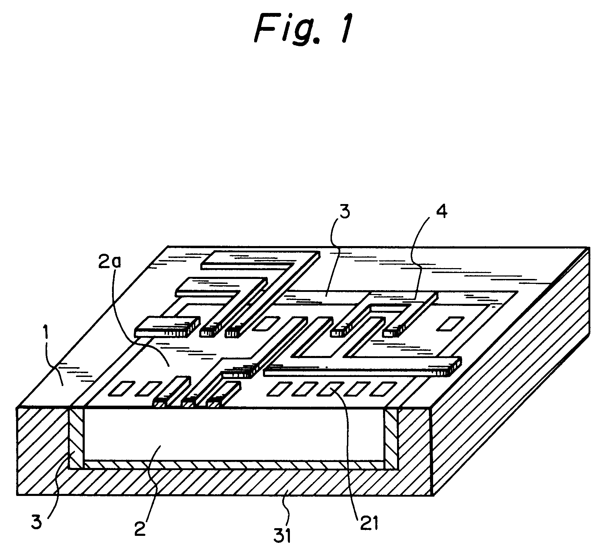

A preferable embodiment according to the present invention will be explained below in reference to Fig. 1.

In Fig. 1, a circuit board assembly includes a printed circuit board 1, an IC chip 2, filler 3, adhesive layer 31, wiring patterns 4. The printed circuit board 1 has plural hollows each for accommodating an IC chip, and is preferably made of polychlorinated biphenyl, epoxy-glass, or ceramics. The printed circuit board 1 may have a single-layered structure or a laminated structure which includes wiring patterns inside thereof.

The IC chip 2 has a plurality of bonding pads 21 on the top surface of 2a thereof, the bonding pads 21 being formed of aluminum. The IC chip 2 is inserted into the hollow in such a manner that the surfaces of the IC chip 2 and the printed circuit board 1 are leveled to each other. The IC chip 2 also is fixed with an adhesive layer 31 coated on the bottom surface of the hollow. The gap between the IC chip and the inner wall of the hollow is filled with an insulating filler 3, for example, a thermosetting polymer resin or a polyimide, having a small thermal expansion coefficient. Since the difference in height between the filler 3 and the top surface of the IC chip 2 or the printed circuit board 1 can be controlled to be within 0.2 to 0.3 $\mu$m, the breakage of the wiring patterns 4 crossing over the gap can be prevented.

The wiring pattern 4 is made of an aluminum layer of 1 $\mu$m thickness. The wiring patterns 4 on both the IC chip 2 and the printed circuit board 1 are formed simultaneously by utilizing an aluminum vaporization. A protective layer, for example, polycrystalline oxide film, not shown in Fig. 1 may be formed over the top surface of the print circuit board 1 to prevent wiring patterns 4 thereover.

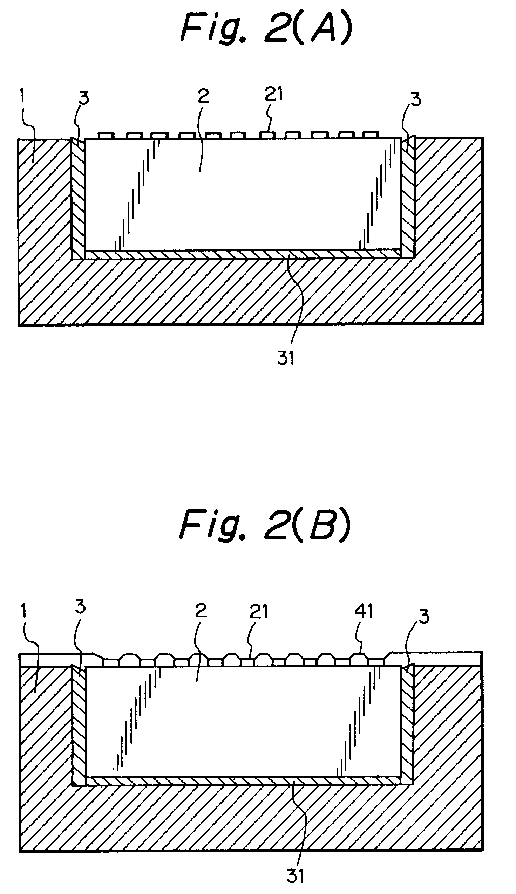

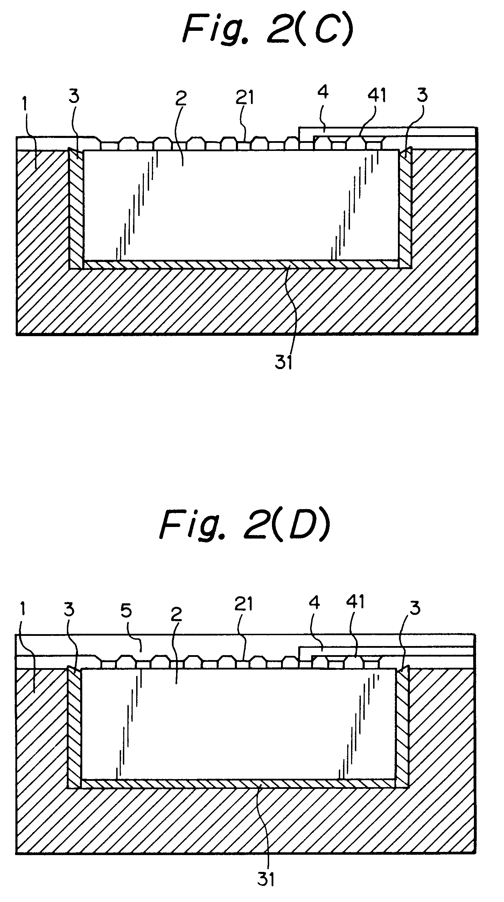

Next, an explanation will be made below as for the method of manufacturing the circuit board assembly shown in Fig. 1, with reference to Figs. 2(A) to 2(D).

In Fig. 2(A), a printed circuit board 1 having a hollow is prepared. An adhesive layer 31 is coated on the bottom surface of the hollow. Then an IC chip 2 which has bonding pads 21 on the top surface thereof is inserted into the hollow and fixed with the An adhesive layer 31. The adhesive layer may be of an epoxy resin. The hollow has a depth equal to or larger than the thickness of the IC chip 2. A filler 3 is injected into the gap between the IC chip 2 and the inner wall of the hollow so as to obtain a leveled surface of the circuit board assembly. The filler 3 may be of a thermosetting polymer resin or a polyimide, having a small thermal expansion coefficient.

In Fig. 2(B), an insulating material layer 41 is formed on the entire surface of the structure of Fig. 1 by spattering an insulating material, for example, phosphor-silicate glass. Then the bonding pads 21 are exposed by carrying out a reactive ion-etching to remove selectively the insulating material layer 41.

In Fig. 2(C), an aluminum film are formed over the entire surface of the structure seen in Fig. 2(B) by vapor-depositing aluminum in a vacuum chamber at a vacuum degree of $10^{-5}$ to $10^{-6}$ Torr. A photo resist film is formed over the entire surface of the aluminum layer by spin-coating a photo resist liquid, and then hardened by heating it at about 90°C. A photo resist mask are formed on the aluminum film by performing a photo-lithographic process to the hardened photo resist mask. Using the photo resist mask, wiring patterns 4 extending from the bonding pads 21 are formed by etching off selectively the aluminum film.

Finally, in Fig. 2(D), a protective film 5 is formed over the entire surface of the structure obtained by the above steps by spattering phosphor-silicate glass.

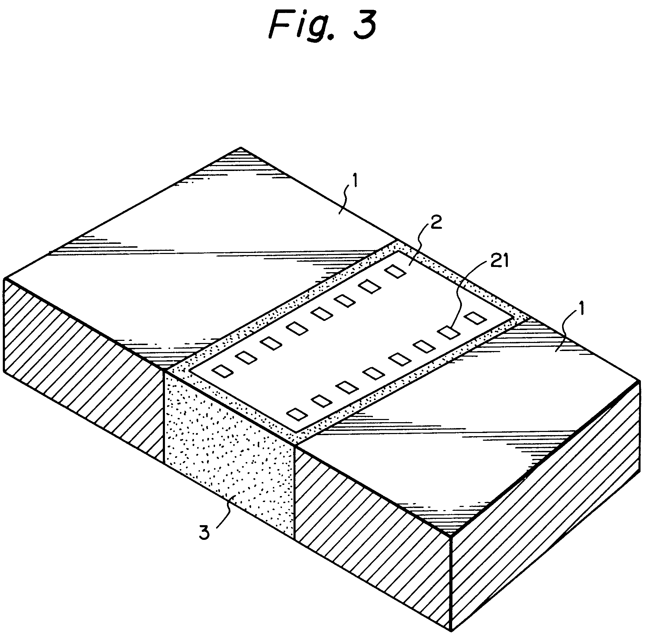

In the above embodiment, the hollow formed in the print circuit board 1 has a closed wall surrounding an IC chip, but may be formed so as to have an open end therein, as shown in Fig. 3. In order to make the structure of Fig. 3, a mold member is used to prevent a filler 3 in liquid from flowing out of the open end of the hollow formed in a printed circuit board 1 to fix the IC chip 2 with the filler 3.

As described above in detail, according to the present invention, since the wire connection to the bonding pads on an IC chip can be performed at the same time together with the formation of wiring patterns on a circuit board, whereby the bonding area can be decreased in comparison with that for the bonding wire. The present invention also can eliminate a special bonding device, thus performing a simplified manufacturing step and lowered cost. Furthermore, according to the present invention, since the length of the wiring can be shortened because of no relaying portion such as a gold wire or solder bump, a high-speed device can be realized.

## Claims

1. A circuit board assembly comprising:

   an electrical insulating circuit board with at least one hollow;

   a semiconductor IC chip mounted in the hollow wherein the upper surfaces of said circuit board and said semiconductor IC chip has the same surface level, said semiconductor IC chip having bonding pads on the upper surface thereof;

   a wiring pattern connected to one of said bonding pads of said semiconductor IC chip and extending over the surface of the insulating circuit board; and

an insulating material layer filled between said semiconductor IC chip and side walls of said hollow so as to fix securely said semiconductor IC chip.

2. A circuit board assembly according to claim 1, wherein said circuit board is made of one selected from a group of polychlorinated biphenyl, epoxy-glass, and ceramics.

3. A circuit board assembly according to claim 1, wherein said insulating material layer is made of a thermosetting resin.

4. A circuit board assembly according to claim 1, wherein said wiring pattern comprises a layer which is made by vapor-depositing aluminum.

5. A method of manufacturing a circuit board assembly comprising the steps of:

preparing an electrical insulating circuit board with at least one hollow, a semiconductor IC chip having bonding pads on the upper surface thereof;

coating an adhesive layer in the hollow of said electrical insulating circuit board;

mounting said IC chips into said hollow of said electrical insulating circuit board so as to make a flat surface of said IC chips and said electrical insulating circuit board;

filling an insulating material between the gap of said semiconductor IC chip and side walls of said hollow so as to fix securely said semiconductor IC chip;

forming wiring patterns on the surfaces of said semiconductor IC chips and said electrical insulating circuit board.

# Fig. 1

# Fig. 2(A)

# Fig. 2(B)

# Fig. 2(C)

# Fig. 2(D)

# Fig. 3